# EUROPÄISCHE PATENTSCHRIFT

(11) **EP 0 647 970 B1**
(45) Veröffentlichungstag und Bekanntmachung des Hinweises auf die Patenterteilung: **30.07.1997**
(21) Anmeldenummer: 94113489.2
(22) Anmeldetag: 30.08.1994
(51) Int. Cl.: H01L 27/02

(54) **Verpolungsschutz für integrierte elektronische Schaltkreise in CMOS-Technik**
Protection against inverted polarity for integrated electronic circuits in CMOS-technology
Protection contre l'inversion de polarité pour des circuits électroniques intégrés dans la technolgie CMOS

(30) Priorität: 09.10.1993 DE 4334515
(43) Veröffentlichungstag der Anmeldung: 12.04.1995
(73) Patentinhaber: Deutsche ITT Industries GmbH, 79108 Freiburg (DE)
(72) Erfinder: Blossfeld, Lothar, Dipl.-Phys., D-79874 Breitnau (DE)

(56) Entgegenhaltungen:
- EP-A- 0 246 139
- EP-A- 0 538 507
- EP-A- 0 573 213

## Beschreibung

Die Erfindung betrifft einen Verpolungsschutz für in CMOS-Technik ausgeführte, monolithisch integrierte elektronische Schaltkreise und insbesondere auch einen Verpolungsschutz für CMOS-Bauelemente selbst.

Der Schutz von elektronischen Schaltkreiselementen gegen falsche Polung, z.B. falscher Anschluß an eine Batterie, ist von erheblicher Bedeutung, insbesondere in der Kraftfahrzeugelektronik, da bei einer Falschpolung die gesamte Schaltung zerstört werden kann und damit ein erheblicher Schaden verursacht wird.

Um die Folgen einer Falschpolung zu vermeiden, ist es aus der Praxis bekannt eine Diode einzubauen. Dies hat bei der Anwendung im Rahmen der CMOS-Technik den Nachteil, daß eine Diode nur in Verbindung mit der "burried layer-Technik" integrierbar ist. Dies bedeutet jedoch zusätzlichen technischen Aufwand und somit erhöhte Kosten, die unbedingt zu vermeiden sind.

Ferner sind aus der EP 0538 507 Widerstands- und Ableiteinrichtungen, insbesondere Ableitdioden, zum Schutz von Anschlußkontakten vor Zerstörung durch ESD-Impulse bekannt.

Der Erfindung liegt deshalb die Aufgabe zugrunde, einen Verpolungsschutz anzugeben, der ohne zusätzliche technische Maßnahmen im Rahmen der herkömmlichen MOS-Technik erzielbar ist.

Die Aufgabe wird durch die im Anspruch 1 angegebene Erfindung gelöst. Zweckmäßige Weiterbildungen der Erfindung sind Gegenstand der Unteransprüche.

Die Erfindung wird nachstehend anhand einer Ausführungsform in Verbindung mit den Figuren 1 bis 3 geschrieben.
Fig. 1 zeigt die Draufsicht auf die Verpolungsschutzanordnung eines p-Kanal-CMOS-Transistors nach der Erfindung,
Fig. 2 zeigt den Schnitt längs der Linie A - A in Fig. 1, und
Fig. 3 zeigt das Ersatzschaltbild der Anordnung nach Fig. 1.

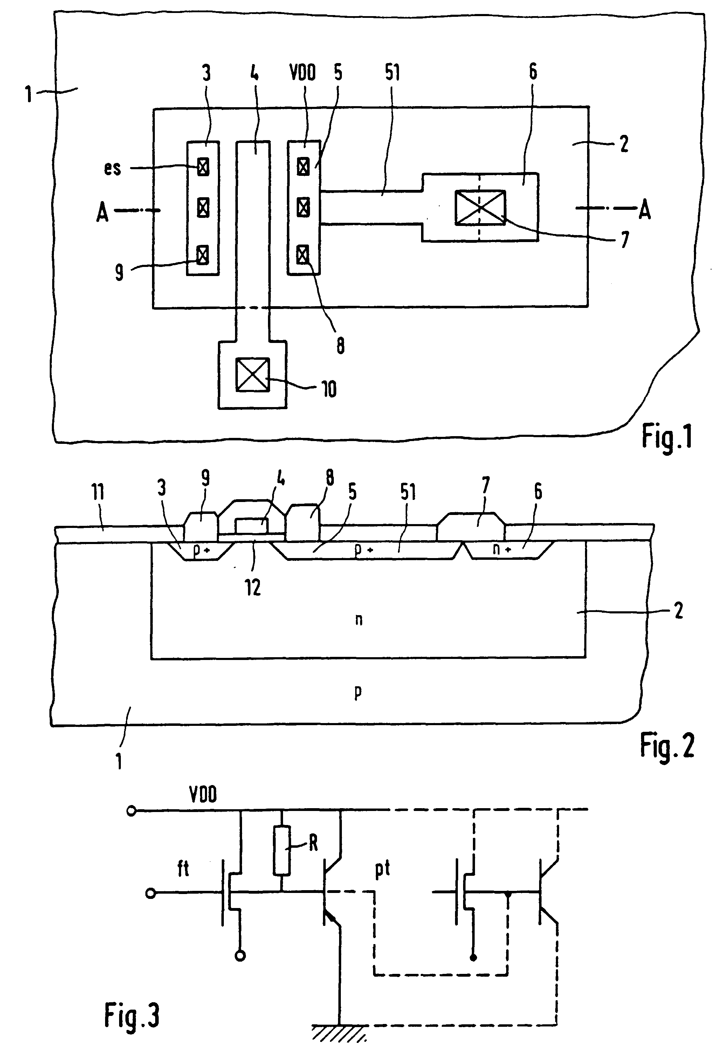

Fig. 1 zeigt das Substrat 1, das entsprechend der meist verbreiteten Form der CMOS-Technik p-dotiert ist. In die Oberfläche des Substrats 1 ist die n-dotierte Wanne 2 eingelassen. Substrat 1 und Wanne 2 sind mit einer in Fig. 1 nicht gezeigten Isolierschicht abgedeckt, in der die erforderlichen Anschlußöffnungen für die darunter liegenden aktiven Zonen ausgespart sind. In der Wanne 2 sind auf herkömmliche Weise die Drainzone 3 und die Source-Zone 5 erzeugt. Zwischen beiden liegt die Gate-Elektrode 4 aus z. B. Polysilicium. An die Source-Zone 5 schließt sich an der von der Gate-Elektrode 4 abgewendeten Seite der Teilbereich 51 an, der bis zum n⁺-dotierten Wannenteil 6 reicht. Die Bezugsziffern 7, 8, 9 und 10 stehen für die jeweiligen Metallanschlußkontakte an den entsprechenden Zonen. Die Source-Zone 5 ist niederohmig an der positiven Versorgungsspannung VDD angeschlossen und an der Drain-Zone 3 liegen die Eingänge es der zu schützenden Schaltung.

Fig. 2 zeigt die Struktur nach Fig. 1 im Schnitt längs der Linie A-A.

In das p-dotierte Substrat 1 ist die n-dotierte Wanne 2 auf herkömmliche Weise eingelassen. Die Oberfläche des Substrats, der Drain-Zone 3, der Source-Zone 5, sowie der hochdotierte Wannenteil 6 sind mit einer Isolierschicht 11 aus z.B. Siliziumdioxid abgedeckt, wobei Anschlußöffnungen in der Isolierschicht 11 für die entsprechenden Anschlußkontakte ausgespart sind, in denen dann der Drain-Kontakt 9, der Source-Kontakt 8 und der Kontakt 7, der den als Widerstand wirkenden Teilbereich 51 zusammen mit dem Wannenteil 6 an die Versorgungsspannung VDD anschließt, angeordnet sind. Über dem Gate-Oxid 12 liegt die Gate-Elektrode 4, die ebenfalls von der Isolierschicht 11 abgedeckt ist.

In dem Ersatzschaltbild nach Fig. 3 liegt der p-Kanal-Transistor ft mit seiner Source-Drain-Strecke zwischen der Versorgungsspannung VDD und der zu schützenden Schaltung. Zwischen der Versorgungsspannung VDD und der Masse liegt ferner der parasitäre, aus der Source-Zone 5 (= Collector), der n-Wanne 2 als Basis und dem Substrat 1 (= Emitter) gebildete pnp-Transistor pt. Zwischen der Basis, (n-Wanne 2) und der Versorgungsspannung VDD liegt ferner der Widerstand R.

In der Fig. 3 sind weitere parasitäre Transistoren gestrichelt eingezeichnet.

Der in den Figuren 1 bis 3 dargestellte p-Kanal-CMOS-Transistor liegt in einer n-Wanne, die normalerweise an die positive Versorgungsspannung gelegt ist. Bei Verpolung bildet die n-Wanne 2 zum Substrat 1 hin eine in Durchlaßrichtung gepolte Diode, die derart viel Strom ziehen kann, daß eine thermische Zerstörung stattfindet. Nachdem in einer CMOS-Schaltung im Normalbetrieb (Sperrichtung) über die n-Wanne nur ein sehr kleiner Strom fließt (<1 nA), kann diese über einen Widerstand an die Versorgungsspannung VDD gelegt werden. Der Widerstand sollte dabei so groß sein, daß er im Verpolungsfall den über die Wanne fließenden Strom begrenzt. Voraussetzung ist dabei, daß der aus dem Source-Gebiet als Kollektor, der n-Wanne als Basis und dem Substrat als Emitter bestehende parasitäre pnp-Transistor eine ausreichend kleine Stromverstärkung besitzt und daß der Stromfluß durch den Widerstand und nicht durch die Stromverstärkung des Transistors bestimmt wird. Diese Bedingung ist stets dann erfüllt, wenn die Stromverstärkung kleiner eins ist (B<1). Voraussetzung dafür ist, daß das Verhältnis der Fläche des Source-Gebietes unter Einbeziehung der Fläche des zusätzlichen Widerstandes R zur Fläche der n-Wanne kleiner als 0,5 ist.

Der Widerstand R kann auch ein mitintegrierter, nicht in der Wanne eingelassener, entsprechend dimensionierter Polysiliziumstreifen sein. In diesem besonderen Fall geht in das zu berücksichtigende Flächenverhältnis nur die Fläche der p-leitenden Source-Zone ein.

Ein anderes Problem bei Halbleiterbauelementen ist der Schutz gegen elektrostatische Entladung, die ebenfalls zu Zerstörungen des Bauelements führt. ESD-geschützte Bauelemente müssen auch den obengenannten Bedingungen entsprechen. Der oben genannte parasitäre pnp-Transistor wirkt dann als ESD-Schutzstruktur. Ein Shunt-Widerstand, der den Einsatzstrom des Vierschichters bestimmt, muß so dimensioniert sein, daß das Zünden weit oberhalb des Betriebsstromes erfolgt.

Als Überspannungsschutz können über den Anschlußkontakt 7 des Wannenteils 6 Überspannungsschutzelemente integriert sein, wie z.B. eine Z-Diode, ein Thyristor oder ein Feldoxidtransistor, dessen Schaltschwelle durch die Feldoxiddicke eingestellt werden kann.

Der große Vorteil der vorliegenden Erfindung liegt darin, daß sie als Verpolungsschutz bzw. Schutzstruktur gegen elektrostatische Entladung ohne zusätzlichen Flächenbedarf, einsetzbar ist, da beide Strukturen quasi immanent ausgebildet werden können.

Diese Flächenersparnis ist von großer Bedeutung. Sie wird noch erhöht dadurch, daß es möglich ist, mehrere n-Wannengebiete über einen Widerstand an die Versorgungsspannung zu legen.

Um eine konstante Stromversorgung zu gewährleisten, kann das Gate des p-Kanal-Transistors an eine stabilisierte Spannung gelegt werden, die niedriger als die Versorgungsspannung ist. Ebenso ist es möglich, das Gate des p-Kanal-Transistors mit der negativen Versorgungsspannung zu verbinden.

## Patentansprüche

1. Verpolschutzanordnung für CMOS-Bauelemente, wobei die Verpolschutzanordnung ausgestattet ist
- mit einem Substrat (1) des einen Leitfähigkeitstyps,
- einer von der einen Hauptfläche aus in das Substrat eingelassenen Wanne (2) vom entgegengesetzten Leitfähigkeitstyp und
- mit in der Wanne (2) eingelassener Source-Zone (5;51) und Drain-Zone (3) vom Substratleitungstyp und wobei
die Souce-Zone (5;51) niederohmig an dem positiven Versorgungsspannungsanschluß (VDD) liegt, an der Drain-Zone (3) die Eingänge der zu schützenden Schaltung liegen, die Wanne (2) über einen Widerstand (R) and dem positiven Versorgungsspannungsanschluß (VDD) liegt und das Verhältnis der Fläche aus der Source-Zone (5;51) zur Fläche der Wanne (2) kleiner als 0.5 ist, so daß die Stromverstärkung des parasitären bipolaren Transistors, dessen Emitter durch das Substrat (1), dessen Basis durch die Wanne (2) und dessen Kollektor durch die Source-Zone (5;51) gegeben sind, kleiner als 1 ist.

2. Anordnung nach Anspruch 1, dadurch gekennzeichnet, daß das Substrat (1) p-dotiert ist.

3. Anordnung nach Anspruch 2, dadurch gekennzeichnet, daß der Widerstand (R) als Teilbereich (51) der Source-Zone (5;51) ausgebildet ist.

4. Anordnung nach Anspruch 2, dadurch gekennzeichnet, daß der Widerstand (R) aus Polysilicium besteht.

5. Anordnung nach Anspruch 4, dadurch gekennzeichnet daß mehrere Wannen über den Widerstand (R) an dem positiven Versorgungsspannungsanschluß (VDD) angeschlossen sind.

6. Anordnung nach einem der obigen Ansprüche, dadurch gekennzeichnet, daß über einen Anschlußkontakt (7) der Wanne (2) zusätzlich Überspannungsschutzelemente angeschlossen sind.

## Claims

1. A polarity-reversal-protection arrangement for CMOS devices, said polarity-reversal-protection arrangement comprising:
- a substrate (1) of one conductivity type;
- a well (2) of the opposite conductivity type formed into the substrate from one major surface; and
- a source region (5; 51) and a drain region (3) of the substrate conductivity type formed into the well (2),
wherein the source region (5; 51) is connected to the positive supply voltage terminal (VDD) via a low-resistivity path, wherein the drain region (3) is connected to the inputs of the circuit to be protected, wherein the well (2) is connected through a resistor (R) to the positive supply voltage terminal (VDD), and wherein the ratio of the area of the source region (5; 51) to the area of the well (2) is less than 0.5, so that the current gain of a parasitic bipolar transistor whose emitter is formed by the substrate (1), whose base is formed by the well (2), and whose collector is formed by the source region (5; 51) is less than unity.

2. An arrangement as claimed in claim 1, characterized in that the substrate (1) is doped p-type.

3. An arrangement as claimed in claim 2, characterized in that the resistor (R) is implemented as a subregion (51) of the source region (5; 51).

4. An arrangement as claimed in claim 2, characterized in that the resistor (R) is made of polysilicon.

5. An arrangement as claimed in claim 4, characterized in that two or more wells are connected through the resistor (R) to the positive supply voltage terminal (VDD).

6. An arrangement as claimed in any one of the preceding claims, characterized in that additional overvoltage protection elements are connected via a contact (7) of the well (2).

## Revendications

1. Agencement de protection contre les inversions de polarité pour composants CMOS, l'agencement de protection contre les inversions de polarité étant équipé :
- d'un substrat (1) d'un premier type de conductivité,
- d'une cuvette (2) ménagée à partir d'une surface principale dans le substrat et d'un type de conductivité opposé, et
- d'une région de source (5; 51) et d'une région de drain (3) ménagée dans la cuvette (2) et du même type de conductivité que le substrat, et dans lequel
la région de source (5; 51) est connectée par une impédance faible à la borne de tension d'alimentation positive (VDD), les entrées du circuit à protéger se situent dans la région de drain (3), la cuvette (2) est soumise via une résistance (R) à la tension d'alimentation positive (VDD) et le rapport de la surface de la région de source (5; 51) à la surface de la cuvette (2) est plus petit que 0,5, de telle sorte que l'amplification de courant du transistor bipolaire parasite, dont l'émetteur est formé par le substrat (1), la base par la cuvette (2) et le collecteur par la région de source (5; 51), soit plus petite que 1.

2. Agencement selon la revendication 1, caractérisé en ce que le substrat (1) présente un dopage p.

3. Agencement selon la revendication 2, caractérisé en ce que la résistance (R) se présente sous la forme d'une sous-région (51) de la région de source (5; 51).

4. Agencement selon la revendication 2, caractérisé en ce que la résistance (R) est constituée de polysilicium.

5. Agencement selon la revendication 4, caractérisé en ce que plusieurs cuvettes sont connectées à la tension d'alimentation positive (VDD) via la résistance (R).

6. Agencement selon l'une quelconque des revendications précédentes, caractérisé en ce que des éléments de protection supplémentaires contre les surtensions sont raccordés via un contact de connexion (7) de la cuvette (2).
